(19) **Europäisches Patentamt**
**European Patent Office**
**Office européen des brevets**

(11) **EP 2 607 932 B1**

(12) **EUROPÄISCHE PATENTSCHRIFT**

(45) Veröffentlichungstag und Bekanntmachung des Hinweises auf die Patenterteilung:
**18.04.2018   Patentblatt 2018/16**

(51) Int Cl.:
***G01V 3/08*** (2006.01)

(21) Anmeldenummer: **11009972.8**

(22) Anmeldetag: **19.12.2011**

(54) **Kapazitives Messverfahren mit steuerbarer Richtwirkung sowie ein hierfür geeigneter kapazitiver Sensor für den Industrieeinsatz**

Capacitative measuring method with controllable directional effect and corresponding capacitative sensor for industrial use

Procédé de mesure capacitif avec directivité commandable et capteur capacitif adapté pour l'usage industriel

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**26.06.2013   Patentblatt 2013/26**

(73) Patentinhaber: **Rechner Industrie-Elektronik GmbH**
**68623 Lampertheim (DE)**

(72) Erfinder:
• **Gebhardt, Stefan**
**68623 Lampertheim (DE)**
• **Bischler, Eduard**
**68623 Lampertheim (DE)**

• **Kohler, Armin Dr.**
**68623 Lampertsheim (DE)**
• **Pok, Ulrich**
**06120 Halle (DE)**

(74) Vertreter: **Bill, Burkart Hartmut**
**Blumbach - Zinngrebe**
**Patent- und Rechtsanwälte PartG mbB**
**Elisabethenstrasse 11**
**64283 Darmstadt (DE)**

(56) Entgegenhaltungen:
WO-A1-90/14604          WO-A1-2010/043936
DE-A1-102009 057 947    US-A1- 2009 321 149
US-B2- 7 821 275

Printed by Jouve, 75001 PARIS (FR)

EP 2 607 932 B1

## Beschreibung

Die Erfindung betrifft ein kapazitives Messverfahren mit steuerbarer Richtwirkung für den Einsatz unter Industriebedingungen, wobei das Messverfahren auf dem 3-Elektrodenmessprinzip basiert, sowie ein hierfür geeigneter kapazitiver Sensor.

Kapazitive Messverfahren und entsprechende kapazitive Sensoren sind heute in der Automatisierungstechnik in der Regel unverzichtbar und decken ein breites Spektrum von Anwendungen ab.

Das Grundprinzip aller Messungen mit kapazitiven Sensoren ist die Erfassung einer Kapazitätsänderung, die durch Präsenz oder Nichtpräsenz eines zu detektierenden Materials im elektrischen Feld der kapazitiven Elektrodenanordnung hervorgerufen wird.

Der Aufbau eines kapazitiven Sensors besteht mindestens aus einer mittels Elektroden aufgebauten Messkapazität sowie einer elektronischen Schaltung, welche die Spannung zur Erzeugung des elektrischen Feldes zwischen den Elektroden liefert und die durch ein Material im elektrischen Feld hervorgerufene Kapazitätsänderung sensorisch auswertet. Die Elektroden der Messkapazität können in unterschiedlichsten Formen gestaltet werden.

So beschreibt z.B. die US 2009/0321149 A1 eine kapazitive Sensoreinrichtung, bei der die Messkapazität Bestandteil einer Oszillatorschaltung ist. Das Grundprinzip entspricht also dem in der Sensortechnik überwiegend angewandten Prinzip, bei dem die Messkapazität eine oder beide Schwingbedingungen eines Oszillators direkt beeinflusst.

Alle in Natur und Technik vorkommenden Stoffe beeinflussen elektrische Felder, was als dielektrische Wirkung bezeichnet wird, oder aber sie sind elektrisch leitfähig. Die dielektrische Wirkung eines jeden Stoffes wird durch seine relative Permittivität $\varepsilon_r$ ausgedrückt. Die relative Permittivität $\varepsilon_r$ für Vakuum, annähernd auch für Luft, ist 1, für andere Stoffe größer 1. Die relative Permittivität stellt einen Faktor dar, um den der Kapazitätswert eines luftgefüllten Kondensators $C_0$ erhöht wird, wenn dessen gesamtes Feldvolumen mit einem Material ausgefüllt wird. In der Praxis ist noch die alte Bezeichnung relative Dielektrizitätskonstante (DK) gebräuchlich. Weil die Permittivität jedoch auch von verschiedenen anderen Parametern, wie Temperatur, Frequenz u.a. abhängen kann, ist die alte Bezeichnung irreführend.

Das bei einer kapazitiven Messung erzeugte Primärsignal ergibt sich aus einer Kapazitätsänderung $\Delta C$, welche für eine sichere Funktion so groß wie möglich sein sollte.

Über die Beziehung:

$$C^* = \varepsilon_r \, C_0$$

wobei

$C_0$ die Messkapazität eines luftgefüllten Kondensators,
$C^*$ die Kapazität des mit einem Material ausgefüllten Kondensators,
$\varepsilon_r$ die relative Permittivität dieses Materials ist und
$\Delta C$ die Kapazitätsänderung ausgehend von $C_0$ bis zu $C^*$ ist, folgt:

$$\Delta C = C^* - C_0;$$

$$\Delta C = (\varepsilon_r - 1) \, C_0.$$

Diese Betrachtung bezieht sich auf eine luftgefüllte Ausgangskapazität, dieser Zusammenhang kann jedoch noch allgemeiner dargestellt werden, wenn die Kapazitätsänderung durch einen Wechsel von Materialien unterschiedlicher relativer Permittivität hervorgerufen wird.

Damit gilt; $\Delta C$ ist proportional zu $\Delta \varepsilon_r$,
sowie $\Delta C$ ist proportional zu $C_0$,
wobei $\Delta \varepsilon_r$ die relative Permittivitätsänderung ausgehend von einem ersten Material zu einem zweiten Material ist.

Die Empfindlichkeit einer kapazitiven Sensoranordnung ist also direkt proportional der relativen Permittivitätsdifferenz zwischen dem zu detektierenden Material und dem Vergleichsmaterial sowie der Größe der Messkapazität. Einer beliebigen Vergrößerung der Messkapazität stehen vor allem technische Probleme, wie z.B. begrenzte Einbauvolumen im Wege.

Mit elektrisch isolierten Messelektroden können auch leitfähige Materialien erfasst werden. Die physikalische Wirkung von elektrischen Leitern und also auch von leitfähigen Materialien zwischen zwei Elektroden kann als eine Abstandsverringerung interpretiert werden, die zu einer Kapazitätserhöhung führt.

In technischen Ausführungen ist die Messkapazität in der Regel eine Teilkapazität einer Elektrodenanordnung. Häufig wird nicht das gesamte Volumen mit dem zu erfassenden Material ausgefüllt, sondern nur ein kleiner Teil. Das führt zu einer Reduzierung der Kapazitätsänderung.

Änderungen der Elektrodenkonfiguration oder der Materialeigenschaften durch thermische Effekte können ebenso Kapazitätsänderungen hervorrufen und müssen durch geeignete Ausführungen klein gehalten werden.

Es gibt eine Vielzahl von unproblematischen Messaufgaben, die in der Praxis gut funktionieren. Das sind solche Fälle, wo Materialien mit hoher dielektrischer Wirkung erfasst werden sollen, wo geringe Abstände erforderlich sind und wo sehr stabile Bedingungen hinsichtlich Temperatur und der Materialparameter, wie z.B. schwankende Feuchtigkeitsanteile, Schüttdichte u. a., vorliegen. Wesentlich ist auch, dass es nicht zu Materialanhaftungen an den Sensoren kommt.

Im Idealfall ist die Messkapazität von der Umgebung unbeeinflusst, was näherungsweise bei sehr großen Abständen zu jeglichen leitfähigen bzw, dielektrischen Materialien, außer zu den Messobjekten gegeben wäre.

Die Elektroden zum Bereitstellen einer Messkapazität müssen jedoch gehaltert werden, wobei sie ferner meist aus Gründen chemischer Beständigkeit und mechanischer Stabilität mit einer isolierenden Beschichtung versehen werden. Darüber hinaus werden die kapazitiven Sensoren üblicherweise an oder in Maschinen bzw. Apparaten installiert und die Abstände zu deren Teilen sind oftmals gering im Verhältnis zu den gewünschten Detektionsabständen. Im Extremfall ist auch bereits die umgebende Luft mit schwankender Luftfeuchtigkeit störend. Es entstehen also unerwünschte, parasitäre Kapazitäten zur Umgebung, die besonders bei hochempfindlichen kapazitiven Messungen zu nicht mehr tolerierbaren Verfälschungen führen.

Bei hochempfindlichen kapazitiven Messungen muss weiterhin berücksichtigt werden, dass die parasitären Kapazitäten obendrein nicht konstant sind. Wesentliche Ursachen dieser Nichtkonstanz sind Abstandsänderungen der Elektroden infolge thermischer Ausdehnungen, Belagbildungen auf der Sensoroberfläche sowie thermisch bedingte Änderungen der dielektrischen Wirkung aller benachbarter Isolationsstoffe.

Damit ist erkennbar, dass der Gestaltung der Messanordnungen eine wesentliche Bedeutung zur Erzielung hoher Empfindlichkeiten und Messkonstanz zukommt.

Die Bezeichnung "hochempfindliche Messung" lässt sich je nach Anwendungserfordernissen sehr unterschiedlich interpretieren.

Hochempfindliche Messungen sind insbesondere erforderlich bei Materialien mit geringer dielektrischer Wirkung, bei großen Abständen zwischen Sensorkopf, welcher in der Regel zumindest eine der Elektroden zum Aufbauen der Messkapazität beinhaltet, und Messobjekten, und/oder bei sehr kleinen Sensorkopfdimensionen, bei kleiner Messobjektgröße u.a.m.

Selbstverständlich sind höchste Messempfindlichkeiten besonders bei kombiniertem Auftreten dieser Anforderungen erforderlich. Außerdem müssen hochempfindliche Messungen auch unter Industriebedingungen funktionieren, das erfordert Temperaturstabilität und weitgehende Unempfindlichkeit gegen Verschmutzungen. Weiterhin wird oft eine Selektivität der Messung gefordert, d.h. die gewünschten Messobjekte sollen bevorzugt gegenüber sonstigen Umgebungsveränderungen erfasst werden.

Es ist Stand der Technik, vor allem temperaturbedingte Änderungen im Bereich einer Messkapazität bzw. der gesamten Messanordnung zu kompensieren.

Eine Variante besteht darin, werkseitig bereits eine Kompensation am Messsystem durchzuführen. Abgesehen davon, dass eine solche Kompensation nur für eine bestimmte Installationsvariante bei kompaktem Aufbau des Messsystems erfolgt, wobei passive Sensorstrukturen und die Elektronik eine kompakte Einheit bilden, kann dadurch nur eine Kurzzeitstabilität garantiert werden.

Weiterhin werden elektronische Kompensationen häufig über punktuelle Temperaturmessungen durchgeführt. Dabei werden jedoch die Bedingungen einer konkreten Einbausituation nur unvollständig berücksichtigt. Die Temperatur ist auch nur ein Umweltfaktor, so dass Feuchtigkeit u.a. unberücksichtigt bleiben.

Es werden auch solche Lösungen angeboten, bei denen langsame temperaturbedingte Änderungen gegenüber den schnellen Messänderungen ausgeblendet werden. Das kann aber zu der Konfliktsituation führen, dass langsame Messänderungen falsch interpretiert werden. Außerdem muss bei solchen Messungen immer die konkrete Messsituation beim Einschalten, d.h. eine Referenzsituation bekannt sein.

Eine aufwändige Lösung besteht darin, bei abgesetzten kapazitiven Messungen, d.h. passive Sensorstrukturen und Elektronik sind über Kabelverbindungen entfernt voneinander angeordnet, mittels identischer Referenzmessungen, die sowohl die passiven Strukturen wie Messkapazität und Kabel als auch die Elektronikkomponenten umfassen, zu kompensieren.

Alle oben beschriebenen Methoden haben den Nachteil, dass sie die Einflüsse von veränderlichen Materialanhaftungen auf den passiven Sensorstrukturen nicht eliminieren können.

Es muss vor allem beachtet werden, dass die Messverfälschungen durch Anhaftungen mit kleiner werdenden Elektrodenabmaßen stark anwachsen. Das ist sofort einleuchtend, wenn man den Fall betrachtet, dass die Dicke der Materialanhaftung in die Größenordnung der Elektrodenabstände kommt.

Das Auswerteprinzip einer kapazitiven 3-Elektrodenmessung, dessen Grundprinzip erstmalig in DE 1 275 777 beschrieben wurde, ermöglicht eine weitgehende Entkopplung der Messelektrode gegenüber der Umgebung.

Zur weiteren Literatur betreffend eine kapazitive 3-Elektrodenmessung, auch bezeichnet z.B. als Dreielektroden-Messprinzip oder Dreielektrodenprinzip, vgl. z.B. Veröffentlichungsreihe "mpa", Bd. 5-2001, Seiten 32 bis 35; Veröffentlichungsreihe "SPS automotive" aus 2005, Seiten 26 und 27 *

Eine weitere Entwicklung dieses Grundprinzips ist zum Beispiel aus der DE102009057947 bekannt. Im Einzelnen basiert eine kapazitive 3-Elektrodenmessung, wie die Bezeichnung bereits angibt, auf 3 Elektroden.

Zwischen 3 Elektroden entstehen zwangsläufig 3 Teilkapazitäten, wobei eine Elektrode das Bezugspotential darstellt. Bei dem 3-Elektrodenmessprinzip wird nur die Änderung der als Messkapazität bezeichneten Teilkapazität ausgewertet. Durch verschiedene schaltungstechnische Maßnahmen werden die Kapazitätsänderungen der anderen Teilkapazitäten in ihrer Wirkung minimiert. Die geometrische Gestaltung der 3 Elektroden ist äußerst komplex. Mit dieser Gestaltung kann jedoch eine sehr weitreichende Optimierung für konkrete Applikationen erfolgen.

Einerseits soll die Messelektrode die "erwünschten" Feldänderungen durch die zu detektierenden Materialien erfassen, andererseits sollen "unerwünschte" Feldänderungen, z. B. durch Materialanhaftungen an der Sensoroberfläche nicht erfasst werden.

Eine Verringerung des Einflusses von Anhaftungen kann erzielt werden, wenn man die Elektroden der Messkapazität gegenüber der Umgebung wirksam entkoppelt. Dazu sind jedoch zusätzliche Elektroden mit entsprechend abschirmend wirkenden Potentialen erforderlich. Bei vielen elektronischen Auswerteprinzipien stehen echte abschirmende Potentiale funktionsbedingt jedoch nicht zur Verfügung.

Das läuft darauf hinaus, dass eine "ideale" kapazitive Messung nur ein von allen störenden Effekten unabhängiges elektrisches Feld umfasst. In diesem als Wirkungsvolumen bezeichenbaren Messfeld sollen ausschließlich die gewünschten Änderungen erfasst werden, das sind alle Zustände vom freien (luftgefüllten) über das teilweise bis total vom zu detektierenden Material ausgefüllte Wirkungsvolumen.

Abgesehen von vielen praktischen Problemen bei der Elektrodengestaltung zur gewünschten Formung des Messfeldes, lässt sich eine völlige Entkopplung zur Umgebung nur mit sehr großen Schirmelektroden bzw. Anregungselektroden (theoretisch ∞) erreichen. Eine völlige Entkopplung zur Umgebung lässt sich mit praxistauglichen Mitteln bisher nicht lösen.

In einigen, dem 3-Elektrodenmessprinzip verwandten Ausführungsformen wird eine die Messelektrode umschließende Elektrode durch aktive Schaltungselemente dem Messelektrodenpotential nachgeführt. Die Abschirmwirkung dieser äußeren Elektrode ist nicht wesentlich größer als die der passiv schirmenden Elektrode beim 3-Elektrodenmessprinzip. Außerdem ist es schaltungstechnisch problematisch, diese Potentialnachführung für größere kapazitive Belastungen und besonders für variable Belastungen stabil gegen Schwingneigungen zu realisieren.

Eine weitere Variante zur besseren Entkopplung besteht darin, die Elektrodenanordnung mit einer äußeren Elektrode zu versehen und diese mit einer differentiellen Auswertung gegenphasig zur Messelektrode zu beaufschlagen. Damit wird eine bessere Entkopplung zur Umgebung erreicht, die Wirkungen veränderlicher parasitärer Kapazitäten werden dadurch jedoch nicht abgeschwächt.

In der Praxis kommen häufig Anwendungen vor, bei denen kapazitive Messungen durch ein Dielektrikum hindurch erfolgen sollen, z.B. die Erfassung des Füllstandes innerhalb eines Glasbehälters.

Das elektrische Feld verläuft damit zwangsläufig auch innerhalb der Glaswandung, wobei in Abhängigkeit von der Wandstärke dieser Feldanteil so groß werden kann, dass hinter der Wand nicht mehr ausreichend Feldanteile für die gewünschte Messung verbleiben. Beim heutigen Stand der Technik können brauchbare Messergebnisse nur mit entsprechend großen Elektrodenabständen, also großen Sensoren erzielt werden.

Die Praxis zeigt, dass mit modernen elektronischen Auswertemethoden weitaus höhere Empfindlichkeiten und Stabilitäten erzielt werden können, als mit den bisher üblichen Elektrodenanordnungen und Kompensationsmethoden für die Gesamtsysteme sinnvoll ist.

Eine Aufgabe der Erfindung besteht darin, ein verbessertes kapazitives Messverfahren für den Einsatz unter Industriebedingungen und einen hierfür geeigneten verbesserten kapazitiven Sensor mit neuer Messfeldgestaltungsmöglichkeit bereitzustellen, so dass insbesondere auch unter zusätzlicher Nutzung angepasster geeigneter Regelalgorithmen zur Feldformung die Einflüsse der parasitären Kapazitäten und weiterer, die gewünschte Messung verfälschender Effekte, wie z.B. die Einflüsse von Dielektrika zwischen Elektroden und Messobjekten sowie Materialansätzen weiter minimiert, bevorzugt gänzlich eliminiert werden können, und damit die Empfindlichkeit und Stabilität kapazitiver Messungen unter extremen Einsatzbedingungen wesentlich erhöht werden können.

Eine weitere Aufgabe ist es, eine von der natürlichen Kugelform abweichende Formung des Messfeldes kapazitiver Sensoren zur optimalen Anpassung an konkrete Mesaaufgaben bereitzustellen. Dabei soll insbesondere eine Bevorzugung der Messempfindlichkeit in einer gewünschten Richtung erfolgen können, z. B. die Annäherung an ein keulenförmiges Messfeld.

Erfindungsgemäße Lösungen sind durch ein kapazitives Messverfahren und einen kapazitiven Sensor mit den Merkmalen der anhängigen Ansprüche gegeben, wobei bevorzugte und/oder vorteilhafte Ausführungsformen und Weiterbildungen Gegenstand der abhängigen Ansprüche sind.

Demgemäß schlägt die Erfindung ein kapazitives Messverfahren für den Einsatz unter Industriebedingungen vor, welches auf dem 3-Elektrodenmessprinzip basiert und bei welchem wenigstens eine erste Elektrode als Anregungselektrode von einem Wechselspannungsgenerator mit einer Wechselspannung beaufschlagt wird, um hierdurch zwischen der Anregungselektrode und einem als zweite Elektrode fungierenden Anlagenpotential ein Anregungsfeld zu erzeugen, und das Potential der Anregungselektrode als Bezugspotential definiert wird bei welchem durch Messobjekte hervorgerufene Potentialänderungen gegenüber der Anregungselektrode von einer dritten Elektrode als Messelektrode erfasst werden,

und wobei eine vierte Elektrode als Entkopplungselektrode eingesetzt wird, die mit einer zur Wechselspannung des Wechselspannungsgenerator inversen Spannung beaufschlagt wird.

Als einen hierfür geeigneten kapazitiven Sensor für den Einsatz unter Industriebedingungen, schlägt die Erfindung einen kapazitiven Sensor vor, der auf dem 3-Elektrodenmessprinzip basiert und eine Elektrodenanordnung besitzt, welche wenigstens eine erste Elektrode als Anregungselektrode umfasst, die an einen Wechselspannungsgenerator anzuschließen ist oder angeschlossen ist, um zwischen einem als zweite Elektrode fungierenden Anlagenpotential und der Anregungselektrode ein Anregungsfeld zu erzeugen, und eine dritte Elektrode als Messelektrode umfasst, welche durch Messobjekte hervorgerufene Potentialänderungen gegenüber der Anregungselektrode erfasst, und wobei die Elektrodenanordnung ferner wenigstens eine vierte Elektrode als Entkopplungselektrode umfasst, welche mit einer zur Wechselspannung des Wechselspannungsgenerators inversen Spannung zu beaufschlagen ist oder beaufschlagt ist.

Die Erfindung ermöglicht hierdurch die o.a. Effekte durch eine neuartige Formung von elektrischen Messfeldern.

Bei dem bekannten 3-Elektrodenmessprinzip erzeugt ein Wechselspannungsgenerator zwischen einer Anregungselektrode und dem Anlagenpotential, welches als zweite Elektrode fungiert und in der Regel identisch mit dem Schutzleiterpotential und nur in Ausnahmefällen nicht geerdet ist, ein Anregungsfeld. Als dritte Elektrode erfasst eine Messelektrode die durch die Messobjekte hervorgerufenen Potentialänderungen gegenüber der Anregungselektrode. Damit ist es sinnvoll, das Potential der Anregungselektrode als Bezugspotential zu definieren, das Anlagenpotential ist dann das "heiße" Potential und die Anregungselektrode besitzt damit eine Abschirmwirkung, weshalb sie häufig auch als Schirmelektrode bezeichnet wird. Das weicht zwar vom allgemein üblichen, auf dem Schutzleiterpotential liegenden Bezug ab, ist jedoch für eine verständliche Beschreibung der kapazitiven 3-Elektrodenmessung notwendig.

Durch die erfindungsgemäße Erweiterung dahingehend, dass wenigstens eine weitere Entkopplungselektrode als vierte Elektrode eingesetzt wird, welche mit einer zur Wechselspannung des ersten Wechselspannungsgenerators inversen Spannung zu beaufschlagen ist oder beaufschlagt ist, ist eine steuerbare Richtwirkung des elektrischen Messfeldes gegeben, welche höchste Messempfindlichkeit und Messkonstanz auch für den Einsatz unter Industriebedingungen bietet.

Zweckmäßig umfasst die Elektrodenanordnung ferner eine zwischen der Anregungselektrode und der Entkopplungselektrode angeordnete fünfte Elektrode als Fühlelektrode, welche zunächst die Anregungselektrode in deren Wirkung um die Fläche der Fühlelektrode vergrößert. Erfindungsgemäss ist vorgesehen, die Amplitude der inversen Spannung zur Beaufschlagung der Entkopplungselektrode über einen Regelverstärker aus dem Potential dieser als Fühlelektrode eingesetzten fünften Elektrode abzuleiten. Hierzu ist der Ausgang des Regelverstärkers zweckmäßig zur Spannungsregulierung an einen zweiten Wechselspannungagenerator anzuschließen bzw. angeschlossen, welcher die inverse Spannung zur Beaufschlagung der Entkopplungselektrode erzeugt. Der Sollwert des Regelverstärkers ist grundsätzlich frei wählbar und kann anwendungsspezifisch dem Potential der Anregungselektrode entsprechen und/oder mit einem einstellbaren Offset zum Potential der Anregungselektrode beaufschlagt sein.

Die Fühlelektrode befindet sich im einfachen Fall zwischen der äußeren Entkopplungselektrode und der Anregungselektrode. Dabei wird das Messfeld in seiner Funktion nicht beeinträchtigt, weil die Fühlelektrode immer stabile Randbedingungen erzeugt. Wird als Sollwert das Potential der Anregungselektrode ausgewählt, kann durch einen Regelalgorithmus das Potential der Fühlelektrode auf dem Potential der Anregungselektrode gehalten werden und verhindert somit eine Beeinflussung des Messfeldes vor der Messelektrode durch unerwünschte Effekte.

Weicht der Sollwert vom Potential der Anregungselektrode ab, wird das Messfeld über die Entkopplungselektrode verformt und kann somit an konkrete Applikationen angepasst werden. Die Unterdrückung unerwünschter Effekte wird aber auch in diesem Falle gewährleistet, da die zweckmäßig eingesetzte Fühlelektrode weiterhin alle Abweichungen erfasst und diesen entgegenwirkt.

Weitere Merkmale und Vorteile der Erfindung werden aus der nachfolgenden Beschreibung bevorzugter Ausführungsformen unter Bezugnahme auf die beigefügten Zeichnungen ersichtlich. Die Zeichnungen zeigen:

Fig. 1 eine schematischen Prinzipskizze einer ersten bevorzugten Ausführungsform im Rahmen der Erfindung,

Fig. 2 eine schematische Prinzipskizze einer zweiten bevorzugten Ausführungsform im Rahmen der Erfindung, wobei Fig. 2a ein axialer Schnitt durch einen Sensorkopf gemäß der Erfindung und Fig. 2b ein Schnitt durch eine Elektrodenebene entlang der Schnittlinie A-A der Fig. 2a ist.

Fig. 3 eine schematische Prinzipskizze einer weiteren bevorzugten Ausführungsform im Rahmen der Erfindung, wobei Fig. 3a und Fig. 3b verschiedene, teilweise geschnittene Ansichten durch einen Behälter mit darin angeordnetem Sensorkopf gemäß der Erfindung sind,

Fig. 4 eine schematische Prinzipskizze einer weiteren bevorzugten Ausführungsform im Rahmen der Erfindung, wobei Fig. 4a eine Teilansicht eines Schnittes durch eine Glaswand mit einem daran angesetztem Sensorkopf gemäß der Erfindung ist und Fig. 4b eine Schnittansicht entlang der Schnittlinie A-A der Fig. 4a ist,

Fig. 5 eine schematische Prinzipskizze einer Anordnung für einen das 3-Elektrodenmessprinzip gemäß Stand der Technik anwendenden kapazitiven Sensor, und

Fig. 6 eine weitere schematische Prinzipskizze einer Anordnung für einen das 3-Elektrodenmessprinzip gemäß Stand der Technik anwendenden kapazitiven Sensor.

Nachfolgend werden verschiedene bevorzugte Ausführungsformen der vorliegenden Erfindung an einigen Ausführungsbeispielen und unter Bezugnahme auf die beigefügten Zeichnungen dargestellt, wobei gleiche oder gleichwirkende Komponenten zumindest teilweise mit den selben Bezugszeichen belegt sind.

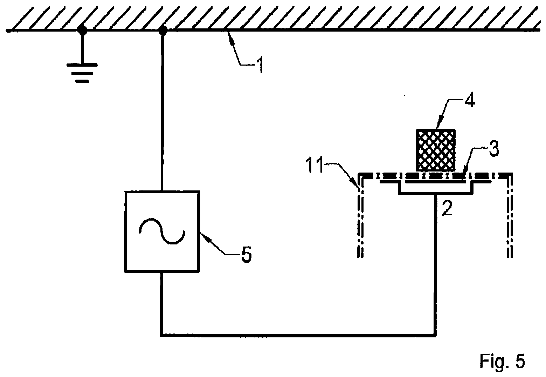

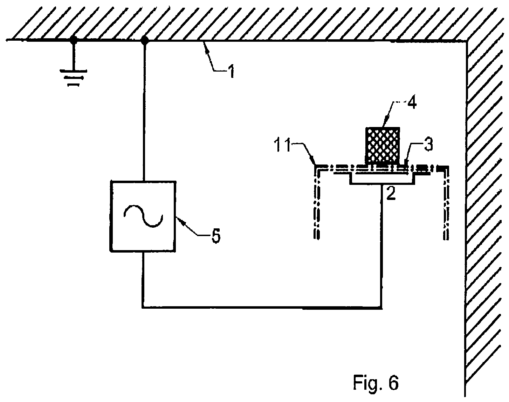

Zum besseren Verständnis des Wesens dieser Erfindung können vorab einige grundsätzliche Bemerkungen an Hand der Figuren 5 und 6, welche schematische Prinzipskizzen von Anordnungen für einen das 3-Elektrodenmessprinzip gemäß Stand der Technik anwendenden kapazitiven Sensor zeigen, hilfreich sein.

Gemäß Ausführungsform nach Fig. 5 erzeugt ein Wechselspannungsgenerator 5 ein elektrisches Feld zwischen einem Anlagenpotential 1 und einer Anregungselektrode 2. Mit der Bezugsziffer 3 ist eine Messelektrode gekennzeichnet, die sich immer nahe bei der Anregungselektrode 2 befindet.

Während die Anregungselektrode 2 in Form und Größe eindeutig definiert ist, sind für das Anlagenpotential 1 Form, Größe und Abstand zu den anderen Elektroden variabel.

Da üblicherweise davon auszugehen ist, dass die Anregungselektrode 2 wesentlich kleiner als die Elektrodenfläche des Anlagenpotentiales 1 ist, wird das elektrische Feld in Messrichtung, d.h. in Richtung zum Anlagenpotential 1, und Nähe der Anregungselektrode 2 dominierend durch deren Form und Größe bestimmt. Da sich üblicherweise auch die Messelektrode 3 immer nahe bei der Anregungselektrode 2 befindet, gilt diese Aussage auch für das Feld vor der Messelektrode 3.

Für die nachfolgenden Betrachtungen soll zunächst abstrahiert werden, dass das Anlagenpotential 1 durch eine ebene Elektrode aus großer Entfernung eingeprägt wird, wobei diese Entfernung immer ein Mehrfaches des Messabstandes zwischen Messelektrode 3 und einem Messobjekt 4 beträgt. Eine, wie bei Figur 5 zu sehen, teilweise wannenförmige Gestalt der Anregungselektrode 2 schirmt die Messelektrode 3 entgegengesetzt zur Messrichtung wirkungsvoll ab.

Diese Betrachtungsweise stellt jedoch den ungünstigsten Fall dar, da sich bei großen Abständen die geringste Feldstärke einstellt. Bei geringer werdenden Abständen steigt die Feldstärke an und die Messobjekte müssen zwangsläufig einen geringeren Abstand zur Messelektrode einhalten, damit wird die Messempfindlichkeit vergrößert.

Die Anregungselektrode 2 sowie die Messelektrode 3 bilden innerhalb einer aus Isoliermaterialien bestehenden äußeren Hülle 11 eine Baueinheit, den Sensorkopf.

In einem Falle kann der Sensorkopf über Koaxialkabel mit allen weiteren elektronischen Komponenten über eine Distanz von mehreren Metern verbunden sein, welche ebenfalls eine Baueinheit bilden können.

Dann handelt es sich um eine abgesetzte Sensorausführung, wobei eine damit ausgeführte Messung den Vorteil besitzt, dass bei entsprechender Ausführung eines demnach rein passiven Sensorkopfes in Bereichen hoher Temperaturen gemessen werden kann.

Im anderen Falle können alle aktiven und passiven Komponenten zu einer Baueinheit zusammengefasst werden, dann handelt es sich um eine kompakte Sensorausführung. Diese kann jedoch wegen der aktiven elektronischen Komponenten in der Regel nur bis maximal 100°C Umgebungstemperatur eingesetzt werden. Auf diese Aspekte soll hier nicht näher eingegangen werden, es existieren hier eine Vielzahl bewährter praktischer Lösungen.

Es sei jedoch darauf hingewiesen, dass Gegenstände nach der Erfindung sowohl in abgesetzten als auch kompakten Varianten von Sensorausführungen eingesetzt werden können.

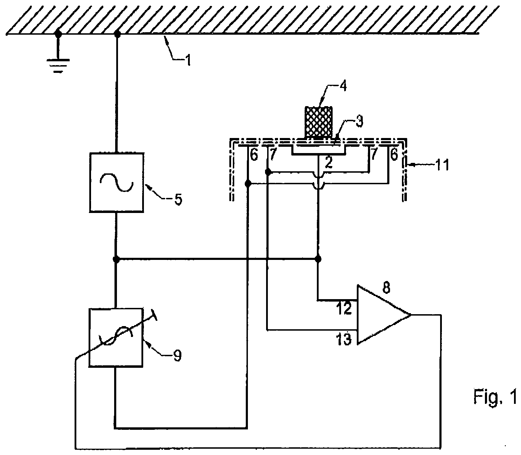

Basierend auf einer Anordnung nach Figur 5 bewirkt das Messobjekt 4 eine Änderung des Potentials der Messelektrode 3, diese Potentialänderung wird über elektronische Baugruppen erfasst, verstärkt und in die gewünschten Ausgangssignale umgeformt. Dieses Auswerteprinzip ist bekannt, weshalb hier nicht weiter darauf eingegangen werden soll und in Fig. 1 die dazu benötigten Komponenten auch nicht dargestellt sind.

Wesentlich ist jedoch, dass nur die Änderung der Teilkapazität zwischen der Messelektrode 3 und dem Anlagenpotential 1 ausgewertet wird. Unter Berücksichtigung der Tatsache, dass sich die Potentiale der Messelektrode 3 und der Anregungselektrode 2 durch ihre Nähe zueinander kaum unterscheiden, entstehen zwei ähnliche Felder, d.h. zwischen dem Anlagenpotential 1 und der Messelektrode 3 sowie zwischen dem Anlagenpotential 1 und der Anregungselektrode 2. In unmittelbarer Nähe vor diesen beiden Elektroden kann das elektrische Feld als annähernd homogen betrachtet werden, wobei das Feld zwischen Anlagenpotential 1 und Anregungselektrode 2 als seitliche Begrenzung für das Messfeldes zwischen Anlagenpotential 1 und Messelektrode 3 fungiert.

Durch diese Eingrenzung entsteht ein definiertes Teilfeld, das mit dem gewünschten Wirkungsvolumen identisch ist, in welchem allein die Erfassung der Messobjekte erfolgt. Diese idealisierte Betrachtung bleibt leider nur so lange sinnvoll, wie entsprechend günstige Dimensionen und Voraussetzungen vorliegen. Der Abstand zwischen Messobjekt 4 und Messelektrode 3 muss daher klein sein, was einer geringen Messempfindlichkeit entspricht. Es sollten auch solche Bedingungen am Einbauort des Messfühlers vorliegen, die der Betrachtungsweise gemäß Fig. 5 gerecht werden. Das erfordert vor allem, dass das Anlagenpotential 1 nicht zusätzlich seitlich vom Sensorkopf eingeprägt wird. Der seitlichen Einprägung des Anlagenpotentials 1 kann z.B durch Vergrößerung der Fläche der Anregungselektrode 2 entgegengewirkt werden. Das führt jedoch zu großen Bauformen der Sensorköpfe und damit zu Konflikten für die praktischen Montageerfordernisse.

Fig. 6 zeigt eine weitere schematische Prinzipskizze einer Anordnung für einen das 3-Elektrodenmessprinzip gemäß Stand der Technik anwendenden kapazitiven Sensor, gemäß welcher diese Zusammenhänge in einer Ebene dargestellt sind. Praktisch erfolgt die Einprägung des Anlagenpotentials jedoch 3-dimensional,

Bei einem ebenfalls 3-dimensionalem Sensorkopf, z.B. in radialsymmetrischer Form bleibt die ebene Betrachtungsweise tendenziell gültig. Hilfreich für das Verständnis über die Auswirkung einer seitlichen Einprägung des Anlagenpotentials 1 ist z.B. die Annahme, dass der seitliche Abstand zwischen Messelektrode 3 und Anlagenpotential 1 in der gleichen Größenordnung wie der Abstand zwischen Messelektrode 3 und Messobjekt 4 liegt.

Bei konstanten Bedingungen ist auch hier eine empfindliche Messung möglich, denn das primäre Messsignal ist die Feldänderung gegenüber einem Ausgangszustand. Durch die eingangs geschilderten Störeffekte, wie thermisch bedingte Abstandsänderungen, unterschiedliche Beläge auf dem Messfühler u.a.m. bleibt das Wirkungsvolumen allerdings nicht mehr konstant. Wenn diese Störeffekte in die Größenordnung der Messsignale kommen, sind solche Messungen folglich nicht mehr fehlerfrei und also nicht sinnvoll.

Mit der Erfindung kann nunmehr jedoch ein Messfeld erzeugt werden, welches weitgehend unabhängig gegenüber den störenden Veränderungen der Umgebung ist, so dass folglich nur die inneren Veränderungen im gewünschten Wirkungsvolumen erfasst werden und also eine steuerbare Richtwirkung des elektrischen Messfeldes gegeben ist.

Mit Fig. 1, welche eine erste bevorzugte Ausführungsform der Erfindung in einer schematischen Prinzipskizze zeigt, kann das Zusammenwirken der Komponenten zur Feldformung veranschaulicht werden.

Die Elektrodenanordnung des kapazitiven Sensors für den Einsatz unter Industriebedingungen nach Fig. 1 besitzt eine erste Elektrode 2 als Anregungselektrode, die an einen Wechselspannungsgenerator 5 anzuschließen ist oder gemäß Fig. 1 bereits angeschlossen ist, um zwischen einem als zweiter Elektrode 1 fungierenden Anlagenpotential und der Anregungselektrode ein Anregungsfeld zu erzeugen. Ferner umfasst die Elektrodenanordnung eine dritte Elektrode 3 als Messelektrode, welche durch Messobjekten 4 hervorgerufene Potentialänderungen gegenüber der Anregungselektrode erfasst.

Der Sensorkopf, welcher nach dem Stand der Technik die Anregungselektrode 2 und die Messelektrode 3 beherbergt, wird gemäß der in Fig. 1 dargestellten Ausführungsform nach den Außenseiten hin zunächst mit wenigstens einer weiteren die Elektrodenanordnung 2 und 3 umfassenden Entkopplungselektrode als vierte Elektrode 6 versehen, welche mit einer zur Wechselspannung des Wechselspannungsgenerator 5 inversen Spannung zu beaufschlagen ist oder gemäß Fig. 1 beaufschlagt ist.

Die Beaufschlagung mit einer zur Wechselspannung des Wechselspannungsgenerators 5 inversen Spannung erfolgt gemäß Figur 1 durch das Ausgangssignal eines zum Wechselspannungsgenerator 5 "inver-sen" Wechselspannungsgenerators 9. Dieses Aus-gangssignal ist, bezogen auf das Potential der Anregungselektrode 2, identisch mit dem Ausgangssignal des Wechselspannungsgenerators 5, jedoch mit entgegen gesetzter Polarität bzw. Amplitude.

Durch die entgegen gesetzte Polarität entsteht zwischen dem Anlagenpotential 1 und der Entkopplungselektrode 6 eine größere Feldstärke als zwischen Anlagenpotential 1 und der Anregungselektrode 2.

Gemäß Ausführungsform nach Figur 1 besitzt die Elektrodenanordnung des Sensorkopfes bevorzugt ferner eine zwischen der Anregungselektrode 2 und der Entkopplungselektrode 6 angeordnete fünfte Elektrode 7 als Fühlelektrode, welche ebenfalls im Sensorkopf angeordnet ist. Die Anregungselektrode 2 wird also in ihrer Wirkung damit zunächst um die Fläche der Fühlelektrode 7 vergrößert. Ferner tastet die Fühlelektrode 7 das in seiner unmittelbaren Nähe herrschende Potential ab.

Die Elektrodenformen der dargestellten Elektroden 2, 6, und 7 sind im Wesentlichen koaxial umeinander herum angeordnet, so dass in der Schnittansicht gemäß Figur 1 zwei gegenüberliegende Teilbereiche der Fühlelektrode 7 auf gegenüberliegenden Seiten der Anregungselektrode 2 und an der radial äußeren Seite eines jeden Teilbereichs der Fühlelektrode 7 wiederum ein jeweiliger Teilbereich der Entkoppelungselektrode 6 zu sehen ist.

Für eine maximale Unempfindlichkeit des Messfeldes gegenüber Umgebungsänderungen ist in praktischer Weise vorzusehen, dass zweckmäßig keine Feldanteile außerhalb des Messvolumens die Messelektrode 3 beeinflussen können bzw. eine Veränderung des Messfeldes bewirken. Durch die äußere Hülle 11 des Sensorkopfes, in stärkerem Maße durch darauf befindliche Materialansätze könnten ansonsten unerwünschte Feldanteile die Barrierewirkung der Anregungselektrode 2 überwinden. Die Überwindung kann umso stärker auftreten, je kleiner die Dimension der Anregungselektrode 2 ist.

In zweckmäßiger Weiterbildung ist ferner ein Regelverstärker 8 vorgesehen, der mit seinem Sollwerteingang 12 an das Potential der Anregungselektrode 2 angeschlossen ist, und mit seinem Istwerteingang 13 an die Fühlelektrode 7 angeschlossen ist. Der Ausgang des Regelverstärker 8 wird an den Wechselspannungsgenerator 9 derart angeschlossen, dass der Regelverstärker 8 die Amplitude des inversen Wechselspannungsgenerators 9 einstellt, wodurch ein geschlossener Regelkreis gebildet werden kann, welcher an der Fühlelektrode 7 das gleiches Potential wie an der Anregungselektrode 2 erzwingt.

Der grundsätzlich frei wählbare Sollwert des Regelverstärkers kann jedoch zusätzlich oder alternativ auch mit einem einstellbaren Offset zum Potential der Anregungselektrode beaufschlagt sein.

Durch die Funktion des bevorzugt geschlossenen Regelkreises wird darüber hinaus eine virtuelle Vergrößerung der Fläche der Anregungselektrode 2 bewirkt. Da, wie oben beschrieben, eine ideale Entkopplung der Messkapazität gegenüber unerwünschten Beeinflussungen mit der Dimension ∞ der Anregungselektrode 2 erreicht wird, kann dieses Ziel nun mit wesentlich kleineren Elektrodenabmaßen erreicht werden. Die Grenzen dieser virtuellen Vergrößerung werden durch die Amplitudenverhältnisse der Wechselspannungsgeneratoren 5 und 9 sowie die Größenverhältnisse der Elektroden zueinander bestimmt.

Für praktisch sinnvolle Messungen werden diese Grenzen nicht überschritten. Es ist verständlich, dass eine kapazitive Messung nicht mehr möglich ist, wenn veränderliche Materialansätze am Sensorkopf wesentlich größer sind, als die Veränderung der Messobjekte 4.

Eine weitere Interpretation der Wirkungsweise der erfindungsgemäßen Komponenten kann mit der Tatsache erfolgen, dass an der äußeren Grenze des abschirmenden Feldes zwischen dem Anlagenpotential 1 und der Anregungselektrode 2 alle Veränderungen ausgeregelt werden. Wenn das von der Anregungselektrode 2 bewirkte Schirmfeld unverändert bleibt, bleibt zwangsläufig auch das Messfeld konstant, somit wird die gewünschte Unabhängigkeit des Messfeldes von allen äußeren Störungen erreicht.

In einer weiteren Ausführungsvariante der Erfindung kann der Sollwerteingang 12 des Regelverstärkers 8 z.B. mit einem anderem Potential als dem der Anregungselektrode 2 beaufschlagt werden. Ein z.B. gegenüber dem Potential der Anregungselektrode 2 negatives Sollwertpotential erzwingt dieses negative Potential dann auch an der Fühlelektrode 7.

Erzielt wird das durch eine Amplitudenvergrößerung des Ausgangssignals des inversen Wechselspannungsgenerators 9. Das von der Anregungselektrode 2 bewirkte abschirmende Feld zwischen Anlagenpotential 1 und Anregungselektrode 2 wird dadurch eingeschnürt und bewirkt nun seinerseits eine Einschnürung des Messfeldes. Bleibt man nun nicht mehr bei einer im Wesentlichen ebenen Anordnung aller vom Sensorkopf umfassten Elektroden, sondern erweitert z.B. die Ausdehnung nach oben, können dadurch gezielt optimierte Geometrien für das Messfeld bzw. Wirkungsvolumen der kapazitiven Messung realisiert werden.

Da Sensorköpfe sehr häufig zylinderförmig und mit einem Einschraubgewinde an der äußeren Hülse ausgebildet sind, haben diese ein etwa kugelförmiges Messfeld vor ihrer Stirnfläche und somit auch eine meist störende "Seitenempfindlichkeit".

Mit Nutzung der erfindungsgemäßen Komponenten können z. B. bei entsprechender Elektrodengestaltung in Messrichtung gestreckte Messfelder und damit geringere Seitenempfindlichkeiten ermöglicht werden. Die Folge ist eine weitgehende Unempfindlichkeit gegenüber seitlichen Materialanhaftungen am Sensorkopf. Materialanhaftungen an der Messelektrodenfläche führen wegen ihres im Verhältnis zum gesamten Messvolumen normalerweise kleinen Volumenanteils zu tolerierbaren Veränderungen der Messempfindlichkeit. Erst wenn das Ansatz-Teilvolumen sich der Größenordnung des Messobjektvolumens annähert, wird die Messempfindlichkeit unzulässig verändert. In diesem Falle sind die Messungen jedoch technologisch unsinnig.

Die Beschreibung der erfindungsgemäßen Effekte erfolgt bewusst lediglich qualitativ. Da mehrdimensionale Feldberechnungen nicht oder nur mit sehr großem Aufwand möglich sind, müssten quantitative Aussagen durch graphische Felddarstellungen untermauert werden. Diese wiederum sind nur bei starken Vereinfachungen und ebenso einfachen Geometrien sinnvoll und werden den Anforderungen hochempfindlicher kapazitiver Messungen nicht gerecht. Zum einen soll hier auf die vielen praktischen Applikationen der traditionellen kapazitiven 3-Elektrodenmeßtechnik verwiesen werden, deren Ergebnisse mit den erfindungsgemäßen Erweiterungen noch wesentlich verbessert werden. Zum anderen erfolgt in weiteren nachfolgenden Ausführungsbeispielen noch eine vertiefende Erläuterung.

Ausführungsbeispiel 1:

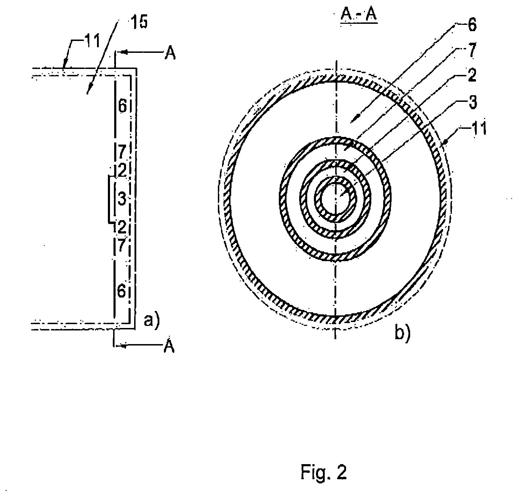

In einem Ausführungsbeispiel soll eine bevorzugte Ausführungsform eines zylindrischen Aufbaus eines Sensorkopfes 15 im Rahmen der Erfindung beschrieben werden. In Fig. 2 sind in Art einer schematischen Prinzipskizze jeweils ein axialer Schnitt durch den Sensorkopf 15 (Fig. 2a) sowie ein radialer Schnitt (Fig. 2b) durch eine Elektrodenebene des Sensorkopfes 15 entlang der Schnittlinie A-A der Fig. 2a dargestellt.*

Die Elektroden 3 und 6 sowie die zweckmäßig eingesetzte Fühlelektrode 6 sind in einer Ebene angeordnet. Lediglich wannenförmigen Teile der Anregungselektrode 2 zur Rückwärtsschirmung sind hiervon ausgenommen. Ein solcher Aufbau ist zweckmäßig mittels einer Leiterplatte leicht zu realisieren. Mit einer z.B. mehrlagigen Platine können ferner die Elektrodenpotentiale entsprechend zueinander abgeschirmt zur Kabelanschlussseite durchgeführt werden. Dieser Aufbau führt somit zu einer hohen Leerlaufkonstanz des Sensorkopfes 15. Veränderungen durch unvermeidliche Wärmebewegungen der Elektroden zueinander sowie temperaturabhängige Veränderungen des dielektrischen Verhaltens der Außenhülle 11 sowie aller zur Halterung der Elektroden erforderlichen Isoliermaterialien können hingegen durch nachfolgende, nicht dargestellte elektronische Auswertungseinrichtungen ausgeregelt werden.

Durch die Dimensionierung der, wie bei Fig. 2b zu sehen, somit bevorzugt kreisförmigen Messelektrode 3, der ringförmigen Elektroden 2, 6, 7 sowie der Abstände zueinander kann das Messfeld bzw. Wirkungsvolumen für die gewünschte Applikation optimiert werden.

In Fig. 2 ist beispielsweise die Entkopplungselektrode 6 großflächiger gegenüber den anderen Elektroden dimensioniert. Damit wird eine besonders geringe Seitenempfindlichkeit für diese Ausführung und eine erhöhte Messempfindlichkeit in Messrichtung erzielt. Das Messfeld bzw. das Wirkungsvolumen wird gegenüber der Kugelform eines herkömmlichen Sensorkopfes keulenförmig nach vorn gestreckt, das Messfeld ist folglich durch eine Richtwirkung gekennzeichnet.

Wegen der ausgezeichneten Leerlaufkonstanz des in Fig. 2 gezeigten Sensorkopfes 15 kann die nachfolgende elektronische Auswertung mit maximaler Verstärkung bis zur Rauschgrenze erfolgen.

Weiterhin ist es möglich, durch Vorgabe eines gegenüber dem Anregungspotential negativen Sollwertes 12 (vgl. Fig. 1) das Messfeld noch weiter einzuschnüren und die Richtwirkung zu verstärken. Wenn die Sollwertvorgabe z.B. mittels Potentiometer erfolgt, kann im praktischen Betrieb eine optimale Anpassung an die Umgebungsbedingungen sowie die Eigenschaften der Messobjekte durchgeführt werden.

zylindrische Sensorköpfe, üblicherweise auch als kapazitive Näherungsschalter bezeichnet, können in zwei grundsätzlichen Einbaulagen montiert werden.

Der messtechnisch einfachere Fall ist die nichtbündige Montage, wobei die sensitive Stirnfläche des Sensorkopfes 15 über die Oberfläche der Umgebung hinausragt. Je weiter dessen Stirnfläche über die das Anlagenpotential 1 einprägende Umgebung hinausragt, desto geringer wird die unerwünschte seitliche Einprägung.

Die messtechnisch schwierigere Einbausituation ist die bündige Montage. Hier liegt die sensitive Stirnfläche in einer Ebene mit der Umgebung. Dabei sind die Entfernungen für die seitliche Einprägung des Anlagenpotentials 1 sehr klein, im Extremfall Null.

Traditionelle kapazitive Näherungsschalter erreichen bei bündigem Einbau kleinere Schaltabstände als bei nichtbündigem Einbau.

Mit der erfindungsgemäßen Ausführung eines Sensorkopfs 15 nach Fig. 2 kann die Seitenempfindlichkeit eines kapazitiven Sensors gemäß Erfindung deutlich verringert werden und durch die verbesserte Leerlaufkonstanz sowie die Minimierung der störenden Beeinflussung durch Materialansätze kann die maximale elektronische Verstärkung ausgenutzt werden. Damit sind auch bei bündigem Einbau höchste Messempfindlichkeiten bei höchster Messkonstanz möglich.

Ausführungsbeispiel 2:

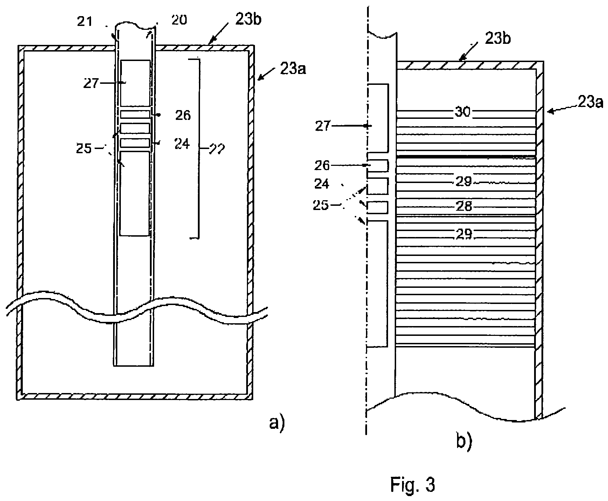

Gemäß Fig. 3 soll in einem metallischen Behälter mit einer Behälterwand 23a als Messobjekt der Füllstand eines Materials, z.B. eines hochviskosen, stark anhaftenden Leimes möglichst dicht unterhalb des metallischen Deckels 23b erfasst werden. Dazu wird eine als Sensorkopf eine Stabsonde 20 benutzt.

Traditionelle kapazitive Füllstandsmessungen versagen bei dieser Aufgabenstellung, weil sich schnell eine Leimbrücke zwischen Deckel und Stabsonde bis zur Messelektrode bildet, es wird dann permanent der Zustand "voll" detektiert.

Alle Elektroden 22 sind zylinderförmig innerhalb einer Isolierhülse 21 in der dargestellten vertikalen Reihenfolge angeordnet. Die Elektroden 22 des Sensorkopfes sind folglich in verschiedenen Ebenen gestaffelt angeordnet. Wegen besserer Übersichtlichkeit sind die Verbindungskabel zur Auswerteelektronik nicht dargestellt. Für eine deutliche zeichnerische Aussage ist ein gewisser vertikaler Abstand zwischen den einzelnen zylinderförmigen Elektroden 22 dargestellt. Optimal ist ein technologisch beherrschbarer minimaler Abstand.

Die Behälterwand 23 wird mit einem bei Fig. 3 nicht dargestellten Wechselspannungsgenerator verbunden und hat die gleiche Wirkungsweise wie das vorstehend beschriebene Anlagenpotential 1.

Die Elektroden 22 sind in zylindrische Elektroden 24, 25, 26 und 27 untergliedert. Die Elektrode 24 bildet die Messelektrode, die Elektroden 25 aufgrund der stabförmigen Sensorkopfausbildung eine zweigeteilte Anregungselektrode, die Elektrode 27 eine Entkopplungselektrode und die zweckmäßige Elektrode 26 eine Fühlelektrode.

Für eine einfache Feldbetrachtung soll der Behälter einen runden Querschnitt haben und die Stabsonde 20 ist zentrisch angeordnet. Damit ergeben sich für den Querschnitt radialsymmetrische Felder 28, 29, 30, wie aus Fig. 3b ersichtlich.

Die sich zwischen den Elektroden 24, 25 und 26 sowie der metallischen Behälterwand 23a erzeugten Felder 28, 29, stellen somit annähernd Zylinderscheiben mit der Höhe der jeweils zugeordneten Elektrode 22 dar.

Die Verschiebungsströme dieser elektrischen Einzelfelder sind bei homogener Füllung des Behälters gleich, Im Bereich der zylindrischen Entkopplungselektrode 27 entsteht durch die inverse Potentialbeaufschlagung eine höhere Feldstärke.

Damit nimmt das der Entkopplungselektrode 27 zugehörige Feld 30 ein größeres Volumen ein. In Fig. 3b ist dieses Feld in einer Schnittansicht idealisiert ebenfalls als eine Zylinderscheibe dargestellt.

Zwar wird sich in der Realität ein solcher idealisierter Feldaufbau kaum ergeben, es ist jedoch nur erforderlich, dass die unteren Feldlinien des Feldes 30 zur äußeren Behälterwand verlaufen und nicht in Richtung Behälterdeckel 23b. Damit werden durch die Wirkung der schirmenden Elektroden 25 und 26 die unteren Feldlinien des Abschirmfeldes 29 waagerecht verlaufen und das Messfeld 28 erhält die gewünschte Form einer zylinderscheibe.

Ohne diese Feldstärkenerhöhung würde das Feld 30 im unteren Bereich, also im zum Feld 29 benachbarten Bereich, nicht bis zur seitlichen Behälterwand 23a reichen, und das Abschirmfeld 29 würde nicht die Zylinderform des Measfeldes 28 erzwingen können.

Beim traditionellen 3-Elektrodenmeßprinzip müsste die vertikale Ausdehnung der oberen Anregungselektrode 25 sehr groß sein, damit keine Überwindung der Blockierwirkung der Anregungselektrode 25 durch Materialansätze an der Stabsonde 20 zwischen Behälterdeckel 23b und Messelektrode 24 erfolgen kann. Die Höhe der oberen Anregungselektrode 25 müsste in diesem Fall größer als der Abstand zwischen der seitlichen Behälterwand 23a und dem Stabsensor 20 sein. Materialansätze würden dann aber immer noch die Messung unzulässig beeinflussen. Damit könnte, besonders bei großen Behälterdurchmessern, keine Messung dicht unter dem Behälterdeckel erfolgen.

Mit der erfindungsgemäßen Lösung hingegen wird, wie schon beschrieben, zweckmäßig eine virtuelle Vergrößerung der Anregungselektrode 25 bewirkt. Zusätzlich wird durch die bevorzugte Potentialabtastung mit der Fühlelektrode 26 jegliche Veränderung durch unterschiedliche Materialansätze ausgeregelt.

Unterhalb der Messelektrode 24 wird im Ausführungsbeispiel gemäß Fig, 3 wegen der dort möglichen großen Dimension der Anregungselektrode 25 auf zusätzliche Elektroden 26 und 27 verzichtet, wobei die Installation einer weiteren Entkopplungselektrode 27 sowie einer weiteren Fühlelektrode 26 aber ebenfalls möglich wäre.

Am Ausführungsbeispiel gemäß Fig. 3 kann eine weitere vorteilhafte Option erläutert werden.

Abgesehen davon, dass die Leimansätze solche Dimensionen annehmen können, die eine Messung technologisch sinnlos machen, gibt es einen Übergangsbereich für die Größe der Materialanhaftungen. Dafür ist eine Aussage dahingehend wünschenswert, ob eine Messung noch möglich ist, oder ob eine Messung nicht mehr möglich ist.

Diese Aussage kann bei einer bevorzugten Ausführungsform der Erfindung, welche einen Regelkreis besitzt, leicht aus dem Regelkreis abgeleitet werden.

Die Grenze für die Kompensation der Ansatzwirkungen ist erreicht, wenn an der Fühlelektrode 26 (bzw. 7 bei Fig. 1) nicht mehr das Potential entsprechend dem Sollwert 12 (Fig. 1) erzwungen werden kann. In dieser Situation befindet sich der Ausgang des Regelverstärkers 8 (Fig. 1) in Sättigung bzw, hat der inverse Wechselspannungsgenerator 9 seinen maximalen Amplitudenwert erreicht. Über einen nicht dargestellten Komparator lässt sich daraus ein Schaltsignal gewinnen, mit dem die Funktionsuntüchtigkeit der Messung nach außen signalisiert wird bzw. bei Grenzüberschreitung das Ausgangssignal der Messung in technologisch sinnvoller Weise zwangsgesetzt wird, beispielsweise für einen Leerlaufschutz.

Mit anderen Worten wird also eine Grenze für die Kompensation veränderlicher Materialansätze am Sensorkopf durch die die Kompensationsgrenze repräsentierenden Spannungswerte des Regelverstärkers bzw. des inversen Anregungssignals angezeigt. Die Spannungswerte des Regelverstärkers bzw. des inversen Anregungssignals ermöglichen daher ferner Aussagen über die Sinnfälligkeit der Messung.

Ausführungsbeispiel 3

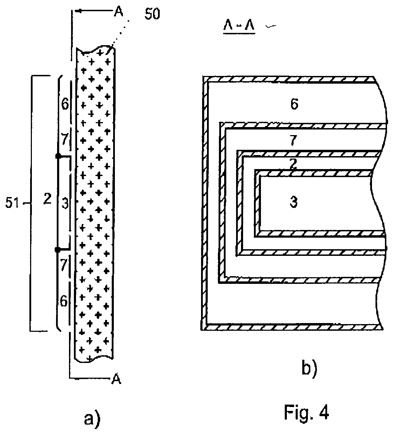

Als ein weiteres bevorzugtes Ausführungsbeispiel im Rahmen der Erfindung wird in Fig. 4 in Art einer schematischen Prinzipskizze eine Standmessung durch eine Glaswand 50 z.B. eines Behälters hindurch dargestellt. Fig. 4a zeigt eine Teilansicht eines Schnittes durch die Glaswand 50 mit einem daran angesetztem Sensorkopf 51 gemäß der Erfindung und Fig. 4b eine Schnittansicht entlang der Schnittlinie A-A der Fig. 4a. Solche Messungen sind dann besonders schwierig, wenn das zu detektierende Material eine kleinere dielektrische Wirkung als das Wandmaterial aufweist, z.B. Kunststoffgranulat mit niedriger Schüttdichte. Große Wanddicken erschweren zusätzlich sichere Messungen, da der Verschiebungsstrom sich dann überwiegend innerhalb der Wand konzentriert.

In Fig. 4 ist ein außen an der Glaswand 50 befindlicher Sensorkopf 51 dargestellt, in diesem Fall zweckmäßig in Art eines Folien-Sensorkopfes 51 in Streifenform. Der Folien-Sensorkopf 51 kann in seiner Längsbzw. Höhenausdehnung im Wesentlichen an jegliche Behältergröße angepasst werden und liefert ein analoges Primärsignal, welches in der nachfolgenden (nicht dargestellten) Elektronik in mehreren Varianten ausgewertet werden kann.

Vorteilhaft ist die Verwendung einer flexiblen Leiterkarte zur Realisierung der Elektroden des Folien-Sensorkopfes 51. Eine Messelektrode 3, sowie die sich seitlich von der Messelektrode 3 befindenden Teile einer Anregungselektrode 2, zweckmäßig wiederum eine Fühlelektrode 7 und eine Entkopplungselektrode 6 liegen in einer Ebene.

Das Anlagenpotential ist bei Fig. 4 zeichnerisch nicht dargestellt, hier wird abstrahiert, dass es von der gesamten Umgebung in die Messanordnung eingeprägt wird. Die Anregungselektrode 2 bildet ferner zweckmäßig hinter allen Elektroden eine durchgehende Fläche und wirkt damit entgegengesetzt zur Messrichtung als eine Abschirmung gegenüber dem Anlagenpotential.

Die Einprägung des Anlagenpotentials ruft demnach in der dielektrisch aktiven Glaswand 50 einen starken Verschiebungsstrom in Richtung aller nahe beim Potential der Anregungselektrode 2 liegenden Elektroden hervor.

Der größte Verschiebungsstrom entsteht jedoch wegen der größten Feldstärke in Richtung zur Entkopplungselektrode 6. Ein für die Messung relevanter Anteil des Verschiebungsstromes in Richtung zur Messelektrode 3 wird durch die Blockierwirkung der Entkopplungselektrode 6 und der in gleicher Richtung liegenden Fühlelektrode 7 und Anregungselektrode 2 unterbunden. Damit kann ein Verschiebungsstrom zur Messelektrode 3 nur über kurze Distanzen, also vorwiegend rechtwinklig zur Glaswand 50 entstehen. Dieser Verschiebungsstrom durchsetzt aber auch zwangsläufig das sich im Behälterinneren (auf der zu dem Folien-Sensorkopf gegenüberliegenden Seite der Glaswand 50) befindliche Material, Somit wird also ein Messfeld dominierend in Richtung Behälterinneres erzeugt und mögliche Störungen von der Vorderseite der Wand, wie z.B. durch Belagbildung, Annäherung geerdeter Teile usw. werden eliminiert.

Basierend auf vorstehender Beschreibung bevorzugter Ausführungsformen eines kapazitiven Sensor gemäß der Erfindung ist offenbar geworden, dass dieser besonders für kapazitive, auf dem 3-Elektrodenmessprinzip basierende Sensormessverfahren für den Einsatz unter Industriebedingungen geeignet ist, bei welchem wenigstens eine erste Elektrode 2, 25 als Anregungselektrode von einem Wechselspannungsgenerator 5 mit einer Wechselspannung beaufschlagt wird, um hierdurch zwischen der Anregungselektrode und einem als zweiter Elektrode 1, 23a, 23b fungierenden Anlagenpotential ein Anregungsfeld zu erzeugen, wobei durch Messobjekte hervorgerufene Potentialänderungen genüber der Anregungselektrode von einer dritten Elektrode 3, 24 als Messelektrode erfasst werden, und sich dadurch auszeichnet, dass eine vierte Elektrode 6, 27 als Entkopplungselektrode eingesetzt wird, die mit einer zur Wechselspannung des Wechselspannungsgenerators 5 inversen Spannung beaufschlagt wird.

Bezugszeichenliste

| | |
|---|---|
| 1 | Anlagenpotential (im Normalfall geerdet) |
| 2 | Anregungselektrode |
| 3 | Messelektrode |
| 4 | Messobjekt |
| 5 | 1. Wechselspannungsgenerator |
| 6 | Entkopplungselektrode |
| 7 | Fühlelektrode |
| 8 | Regelverstärker |
| 9 | 2. inverser Wechselspannungsgenerator |
| 11 | Äußere Hülle des Sensorkopfes |
| 12 | Sollwert |
| 13 | Istwert |
| 15 | Sensorkopf |
| 20 | Stabsonde |
| 21 | Isolierhülse |
| 22 | zylindrische Elektroden, allgemein |
| 23a | seitliche Behälterwand |
| 23b | Behälterdeckel |
| 24 | Messelektrode |
| 25 | zylindrische Anregungselektrode |
| 26 | zylindrische Fühlelektrode |
| 27 | zylindrische Entkopplungselektrode |
| 28 | Messfeld |
| 29 | Abschirmfeld der Anregungselektrode |
| 30 | Entkopplungsfeld |
| 50 | Glaswand z.B. eines Behälters |
| 51 | Sensorkopf |

**Patentansprüche**

1. Kapazitives Messverfahren für den Einsatz unter Industriebedingungen, wobei das Messverfahren auf dem 3-Elektrodenmessprinzip basiert,

   bei welchem wenigstens eine erste Elektrode (2, 25) als Anregungselektrode von einem ersten Wechselspannungsgenerator (5) mit einer Wechselspannung beaufschlagt wird, um hierdurch zwischen der Anregungselektrode und einem als zweiter Elektrode (1, 23a, 23,b) fungierenden Anlagenpotential ein Anregungsfeld zu erzeugen,
   wobei das Potential der Anregungselektrode als Bezugspotential definiert wird und durch Messobjekte hervorgerufene Potentialänderungen gegenüber der Anregungselektrode von einer dritten Elektrode (3, 24) als Messelektrode erfasst werden, und welches **dadurch gekennzeichnet ist, dass**
   eine vierte Elektrode (6, 27) als Entkopplungselektrode eingesetzt wird, die mit einer zur Wechselspannung des Wechselspannungsgenerator inversen Spannung beaufschlagt wird, wodurch eine steuerbare Richtwirkung des elektrischen Messfeldes bereitgestellt wird,

   wobei die Amplitude der inversen Spannung zur Beaufschlagung der Entkopplungselektrode über einen Regelverstärker (8) aus dem Potential einer als Fühlelektrode eingesetzten fünften Elektrode (7, 26) abgeleitet wird.

2. Kapazitives Messverfahren nach Anspruch 1, **dadurch gekennzeichnet, dass** der Sollwert (12) des Regelverstärkers dem Potential der Anregungselektrode entspricht und/oder, dass der Sollwert des Regelverstärkers mit einem einstellbaren Offset zum Potential der Anregungselektrode beaufschlagt wird.

3. Kapazitives Messverfahren nach Anspruch 1 oder 2, **gekennzeichnet dadurch, dass** eine Grenze für die Kompensation veränderlicher Materialansätze am Sensorkopf durch die die Kompensationsgrenze repräsentierenden Spannungswerte des Regelverstärkers bzw. des inversen Anregungssignals angezeigt wird.

4. Kapazitiver Sensor für den Einsatz unter Industriebedingungen, wobei der Sensor auf dem 3-Elektrodenmessprinzip basiert und einen Sensorkopf mit einer Elektrodenanordnung besitzt,
   welche wenigstens eine erste Elektrode (2, 25) als Anregungselektrode umfasst, die an einen Wechselspannungsgenerator (5) anzuschließen ist oder angeschlossen ist, um zwischen der Anregungselektrode und einem als zweiter Elektrode (1, 23a, 23,b) fungierenden Anlagenpotential ein Anregungsfeld zu erzeugen,

wobei die Elektrodenanordnung ferner eine dritte Elektrode (3, 24)als Messelektrode umfasst, welche durch Messobjekte (4) hervorgerufene Potentialänderungen gegenüber der Anregungselektrode erfasst, so dass das Potential der Anregungselektrode als Bezugspotential definiert werden kann,

wobei die Elektrodenanordnung ferner wenigstens eine Entkopplungselektrode als vierte Elektrode (6, 27) umfasst, welche mit einer zur Wechselspannung des Wechselspannungsgenerator inversen Spannung zu beaufschlagen ist oder beaufschlagt ist, und wobei die Amplitude der inversen Spannung zur Beaufschlagung der Entkopplungselektrode über einen Regelverstärker (8) aus dem Potential einer als Fühlelektrode eingesetzten fünften Elektrode (7, 26) abgeleitet wird.

5. Kapazitiver Sensor nach Anspruch 4, wobei die als Fühlelektrode eingesetzte fünfte Elektrode (7, 26) in der Elektrodenanordnung zwischen der Anregungselektrode und der Entkopplungselektrode angeordnet ist.

6. Kapazitiver Sensor nach Anspruch 5, wobei die Fühlelektrode an den Istwerteingang (13) eines Regelverstärkers (8) mit wählbarem Sollwert (12) anzuschließen ist oder angeschlossen ist, und der Ausgang des Regelverstärkers zur Spannungsregulierung an einen zweiten Wechselspannungsgenerator (9) anzuschließen ist oder angeschlossen ist, welcher die inverse Spannung zur Beaufschlagung der Entkopplungselektrode erzeugt.

7. Kapazitiver Sensor nach Anspruch 6, wobei die Anregungselektrode an den Sollwerteingang des Regelverstärkers für den wählbaren Sollwert anzuschließen ist oder angeschlossen ist.

8. Kapazitiver Sensor nach einem der vorstehenden Ansprüche 4 bis 7, wobei eine Reihenfolge der Elektrodenanordnung derart ist, dass ausgehend von der Messelektrode in wenigstens eine Richtung sich zunächst die Anregungselektrode anschließt und die Entkopplungselektrode die Reihenfolge in dieser Richtung abschließt.

9. Kapazitiver Sensor nach einem der vorstehenden Ansprüche 4 bis 8, **dadurch gekennzeichnet, dass** die Elektroden der Elektrodenanordnung im Wesentlichen in einer Ebene angeordnet sind.

10. Kapazitiver Sensor nach einem der vorstehenden Ansprüche 4 bis 8, **dadurch gekennzeichnet, dass** die Elektroden der Elektrodenanordnung in verschiedenen Ebenen gestaffelt angeordnet sind.

**Claims**

1. A capacitive measuring method for use under industrial conditions, the measuring method being based on the 3-electrode measuring principle,

wherein at least one first electrode (2, 25) as an excitation electrode has an AC voltage applied thereto by a first AC voltage generator (5) to thereby generate an excitation field between the excitation electrode and a system potential that is effective as a second electrode (1, 23a, 23b); wherein the potential of the excitation electrode is defined as a reference potential, and potential changes with respect to the excitation electrode as caused by measured objects are detected by a third electrode (3, 24) as a measuring electrode;

and which is **characterized in that**

a fourth electrode (6, 27) is used as a decoupling electrode, which has a voltage applied thereto which is inverse to the AC voltage of the AC voltage generator, thereby providing a controllable directional effect of the electric measuring field;

wherein the amplitude of the inverse voltage to be applied to the decoupling electrode is derived, via a control amplifier (8), from the potential of a fifth electrode (7, 26) that is used as a sensing electrode.

2. The capacitive measuring method according to claim 1, **characterized in that** the target value (12) of the control amplifier corresponds to the potential of the excitation electrode, and/or that the target value of the control amplifier is subjected to an adjustable offset to the potential of the excitation electrode.

3. The capacitive measuring method according to claim 1 or 2, **characterized in that** a limit for the compensation of variable material agglomerations on the sensor head is indicated by the voltage values of the control amplifier or of the inverse excitation signal representing the compensation limit.

4. A capacitive sensor for use under industrial conditions, wherein the sensor is based on the 3-electrode measuring principle and comprises a sensor head with an electrode arrangement

which comprises at least one first electrode (2, 25) as an excitation electrode which can be or which is connected to an AC generator (5) to generate an excitation field between the excitation electrode and a system potential that is effective as a second electrode (1, 23a, 23b); wherein the electrode arrangement further comprises a third electrode (3, 24) as a measuring electrode which detects potential changes with respect to the excitation electrode as caused by measured objects (4), so that the potential of the excitation electrode can be defined as a reference potential;

wherein the electrode arrangement further comprises at least one decoupling electrode as a fourth electrode (6, 27), which can have or which has a voltage applied thereto which is inverse to the AC voltage of the AC voltage generator; and

wherein the amplitude of the inverse voltage to be applied to the decoupling electrode is derived, via a control amplifier (8), from the potential of a fifth electrode (7, 26) that is used as a sensing electrode.

5. The capacitive sensor according to claim 4, wherein the fifth electrode used as the sensing electrode is arranged in the electrode arrangement between the excitation electrode and the decoupling electrode.

6. The capacitive sensor according to claim 5, wherein the sensing electrode can be or is connected to the actual value input (13) of a control amplifier (8) with selectable target value (12), and wherein for voltage control, the output of the control amplifier can be or is connected to a second AC voltage generator (9) which generates the inverse voltage to be applied to the decoupling electrode.

7. The capacitive sensor according to claim 6, wherein the excitation electrode can be or is connected to the target value input of the control amplifier for the selectable target value.

8. The capacitive sensor according to any one of the preceding claims 4 to 7, wherein an order of the electrode arrangement is such that starting from the measuring electrode first the excitation electrode is arranged adjacent thereto in at least one direction, and the decoupling electrode completes the order in this direction.

9. The capacitive sensor according to any one of the preceding claims 4 to 8, **characterized in that** the electrodes of the electrode arrangement are substantially arranged in a single plane.

10. The capacitive sensor according to any one of the preceding claims 4 to 8, **characterized in that** the electrodes of the electrode arrangement are arranged in staggered manner in different planes.

**Revendications**

1. Procédé de mesure capacitif destiné à être utilisé dans des conditions industrielles, le procédé de mesure étant fondé sur le principe de mesure par 3 électrodes,

par lequel au moins une première électrode (2, 25) est alimentée en tant qu'électrode d'excitation par un premier générateur de courant alternatif (5) avec un courant alternatif pour ainsi produire un champ d'excitation entre l'électrode d'excitation et un potentiel d'installation agissant en tant que deuxième électrode (1, 23a, 23,b),

dans lequel le potentiel de l'électrode d'excitation est défini en tant que potentiel de référence et des changements de potentiel vis-à-vis de l'électrode d'excitation provoqués par des objets de mesure sont saisis par une troisième électrode (3, 24) en tant qu'électrode de mesure,

et lequel est **caractérisé en ce que** :

une quatrième électrode (6, 27) est installée en tant qu'électrode de découplage qui est alimentée avec une tension inverse du courant alternatif du générateur de courant alternatif, par lequel une directionalité gouvernable du champ d'excitation électrique est mise à disposition,

dans lequel l'amplitude de la tension inverse pour l'alimentation de l'électrode de découplage est dérivée par un amplificateur de réglage (8) depuis le potentiel d'une cinquième électrode (7, 26) installée en tant qu'électrode de détection.

2. Procédé de mesure capacitif selon la revendication 1, **caractérisé en ce que** la valeur de consigne (12) de l'amplificateur de réglage correspond au potentiel de l'électrode d'excitation et/ou **en ce que** la valeur de consigne de l'amplificateur de réglage est alimentée avec un décalage réglable pour le potentiel de l'électrode d'excitation.

3. Procédé de mesure capacitif selon la revendication 1 ou 2, **caractérisé en ce qu'**une frontière pour la compensation de dépôts de matériau changeants est affichée au niveau de la tête de capteur au travers des valeurs de tension représentant la frontière de compensation de l'amplificateur de réglage ou du signal d'excitation inverse.

4. Capteur capacitif destiné à être utilisé dans des conditions industrielles, le capteur étant fondé sur le principe de mesure par 3 électrodes et possédant une tête de capteur avec un agencement d'électrodes,

lequel comprend au moins une première électrode (2, 25) en tant qu'électrode d'excitation, qui doit être ou est raccordée à un générateur de courant alternatif (5), pour produire un champ d'excitation entre l'électrode d'excitation et un potentiel d'installation agissant en tant que deuxième électrode (1, 23a, 23,b)

dans lequel l'agencement d'électrodes comprend en outre une troisième électrode (3, 24) en tant qu'électrode de mesure, laquelle saisit des changements de potentiel vis-à-vis de l'électrode d'excitation provoqués par des objets de mesure (4), de telle sorte que le potentiel de l'électrode d'excitation peut être défini en tant que potentiel de référence, dans lequel l'agencement d'électrodes comprend en outre au moins une électrode de découplage en tant que quatrième électrode (6, 27), laquelle doit être ou est alimentée avec une tension inverse du courant alternatif du générateur de courant alternatif, et dans lequel l'amplitude de la tension inverse pour l'alimentation de l'électrode de découplage est dérivée par un amplificateur de réglage (8) depuis le potentiel d'une cinquième électrode (7, 26) installée en tant qu'électrode de détection.

5. Capteur capacitif selon la revendication 4, dans lequel la cinquième électrode installée en tant qu'électrode de détection est agencée dans l'agencement d'électrodes entre l'électrode d'excitation et l'électrode de découplage.

6. Capteur capacitif selon la revendication 5, dans lequel l'électrode de détection doit être ou est raccordée à une entrée de valeur réelle (13) d'un amplificateur de réglage (8) avec une valeur de consigne (12) pouvant être choisie, et la sortie de l'amplificateur de réglage doit être ou est raccordé pour un réglage de la tension à un second générateur de courant alternatif (9), lequel produit la tension inverse pour l'alimentation de l'électrode de découplage.

7. Capteur capacitif selon la revendication 6, dans lequel l'électrode d'excitation doit être ou est raccordée à l'entrée de valeur de consigne de l'amplificateur de réglage pour la valeur de consigne pouvant être choisie.

8. Capteur capacitif selon l'une quelconque des revendications précédentes 4 à 7, dans lequel un ordre de l'agencement d'électrodes est tel qu'en partant de l'électrode de mesure dans au moins une direction se raccorde tout d'abord l'électrode d'excitation, et l'électrode de découplage termine l'ordre dans cette direction.

9. Capteur capacitif selon l'une quelconque des revendications précédentes 4 à 8, **caractérisé en ce que** les électrodes de l'agencement d'électrodes sont agencées sensiblement dans un même plan.

10. Capteur capacitif selon l'une quelconque des revendications précédentes 4 à 8, **caractérisé en ce que** les électrodes de l'agencement d'électrodes sont agencées de façon échelonnée dans différents plans.

Fig. 1

Fig. 2

Fig. 3

a)

b)

Fig. 4

Fig. 5

Fig. 6

**IN DER BESCHREIBUNG AUFGEFÜHRTE DOKUMENTE**

**In der Beschreibung aufgeführte Patentdokumente**

- US 20090321149 A1
- DE 1275777
- DE 102009057947

**In der Beschreibung aufgeführte Nicht-Patentliteratur**

- mpa. *Veröffentlichungsreihe,* vol. 5-2001, 32-35
- SPS automotive. *Veröffentlichungsreihe,* 2005, 26-27